# DEMANDE DE BREVET EUROPEEN

(11) **EP 2 068 157 A1**
(43) Date de publication de la demande: **10.06.2009**
(21) Numéro de dépôt: 08291143.9
(22) Date de dépôt: 03.12.2008
(51) Int. Cl.: G01R 15/24, G01R 15/18, B60M 1/02, B60L 3/12, G01R 31/00, G01R 15/14

(54) **Installation de mesure pour le comptage d'énergie d'alimentation d'un matériel roulant**

(30) Priorité: 03.12.2007 FR 0759508
(71) Demandeur: Faiveley Transport Tours, 37700 Saint Pierre des Corps (FR)
(72) Inventeur: Coyaud, Martin, 37000 Tours (FR)
(74) Mandataire: Novagraaf IP

(57) **Abrégé**

La présente invention a pour objet une installation de mesure pour le comptage d'énergie d'alimentation, en courant et en tension d'un matériel roulant, permettant la protection de l'utilisateur à l'encontre d'un milieu de mesure hostile et caractérisée par un encombrement réduit et une facilité d'utilisation. Pour ce faire, l'invention propose de capter les paramètres de mesure sur des moyens d'alimentation de matériels roulants par une liaison souple (17) associée à un capteur de tension et/ou de courant et procurant une isolation électrique. L'installation comporte en outre un composant de type une fibre optique (8, 9; 17) s'enroulant sur un support (12) des moyens d'alimentation.

## Description

L'invention concerne une installation de comptage d'énergie d'alimentation d'un matériel roulant, par mesure de l'intensité et de la tension fournies.

L'invention s'applique dans le domaine des transports roulants électriquement alimentés et en particulier, mais non exclusivement, au transport ferroviaire.

Il est traditionnel, dans l'état de la technique, de mesurer les énergies d'alimentation d'un matériel roulant par le biais de moyens de mesure isolés. Ce type d'installation est relié aux caténaires d'alimentation des matériels roulants et comporte par exemple des transformateurs à bobines, primaire et secondaire, ou encore des capteurs à effet Hall. Ces moyens sont disposés en liaison avec les supports des moyens d'alimentation et possèdent des dimensions proches du mètre et un poids important, supérieur à 100 kg.

Ainsi, dans le document DE 101 34 014.1-35, il est décrit un transformateur utilisé pour la mesure de paramètres de puissance et assurant la protection galvanique de l'utilisateur. Son encombrement est comparable à un support d'isolateur de distribution électrique conventionnelle, destiné à soutenir les conducteurs électriques nus, dont le diamètre est de l'ordre de 60 cm.

Par conséquent, la manipulation de ces transformateurs est difficile et devient problématique lors de leur mise en place, de leur changement ou de leur maintenance.

Par ailleurs, il est également connu de réaliser ces mesures par l'intermédiaire de plots isolés par surmoulage, disposés dans la plate-forme montée immédiatement sur le toit de la locomotive et servant de base de fixation d'un pantographe. Le plot est alors relié à un shunt réalisant une mesure de tension. Cette tension étant l'image de courant d'alimentation, sa mesure est ensuite utilisée pour calculer l'intensité correspondante en appliquant la loi d'Ohm.

En effet, comme décrit dans le document FR 2 706 619, ce type d'installation permet de mesurer des courants par l'intermédiaire d'une chute de tension exercée dans la résistance du shunt. Cette chute de tension étant représentative du courant traversant la résistance, il est possible de l'utiliser pour réaliser des mesures des paramètres de puissance délivrés par une caténaire. Cette installation possède un encombrement réduit par rapport aux transformateurs de mesures. Toutefois, la résistance du shunt est soumise à des augmentations de températures importantes par effet Joule. La nécessité d'assurer son refroidissement engendre par conséquent un volume d'installation important. Par ailleurs, la tension mesurée doit être transmise aux moyens de calculs de manière isolée. Cet isolement se fait par l'intermédiaire de transformateurs qui sont eux aussi volumineux. Dans ces conditions, les plots mesurant le courant traversant les caténaires ont un volume conséquent.

Ces types d'installations présentent donc de nombreuses contraintes : les mesures sont effectuées en milieu pollué - caténaires encrassées par les poussières de carbone des pantographes, étincelles -, et en milieu agressif et dangereux en présence de hautes tensions supérieures à 750V et pouvant atteindre maintenant 25kV. La nécessité d'obtenir des mesures fiables implique un entretien régulier des plots. De plus, les hautes tensions environnantes nécessitent des équipements à fort isolement qui entraînent un volume d'installation particulièrement élevé.

En outre, le temps d'immobilisation de la locomotive du matériel roulant pour le changement des moyens de mesure est très important du fait de la taille de la structure des transformateurs ou des plots. Ce problème est encore plus critique pour les anciennes générations de locomotives dont la structure n'est pas nécessairement adaptée à recevoir de tels moyens (poids et volume) sur leur toit.

Pour satisfaire ces besoins et pallier les inconvénients susmentionnés, l'invention propose de capter les paramètres de mesure par des moyens aisés d'installation sur site offrant, avantageusement, un fort isolement en milieu pollué et une facilité d'installation nettement améliorés.

Plus précisément, la présente invention a pour objet une installation de mesure pour le comptage d'énergie d'alimentation d'un matériel roulant comportant des moyens d'alimentation de puissance fournis en liaison avec le matériel roulant. Dans cette installation, une liaison souple est composée d'au moins une fibre optique associée à un capteur de courant des moyens d'alimentation, la fibre étant apte à transmettre une information de courant par modulation d'un flux lumineux introduit dans la fibre à travers le capteur de courant formé par un enroulement de la fibre optique autour d'un support des moyens d'alimentation de puissance, l'information étant transmise à des moyens de démodulation connectés à des moyens de calcul de puissance.

Selon des modes de réalisation particuliers :
- la liaison souple a également une fonction d'isolation électrique ;
- un moyen d'émission introduisant une lumière cohérente dans la fibre optique, l'enroulement de la fibre autour d'un conducteur en sortie de pantographe est apte à délivrer un courant modulé en fonction du nombre de tours autour du conducteur ;
- la mesure est effectuée à partir des variations d'intensité lumineuse induites par l'enroulement en sortie de la fibre optique proportionnellement au nombre de tours réalisé autour du conducteur, les variations lumineuses étant recueillies et transformées en valeurs d'intensité par un système de démodulation, disposé en sortie de la fibre optique et connecté à des moyens de calcul de puissance aptes à traiter ces valeurs d'intensité ;
- un capteur de tension peut être également prévu en complément par modulation d'une lumière cohérente à l'aide d'un élément optique, la modulation étant induite par un champ électrique créé par la tension des moyens d'alimentation, la lumière cohérente étant acheminée en entrée de l'élément optique par une première fibre optique, par exemple depuis une diode laser, l'élément optique étant relié en sortie à une seconde fibre optique guidant ladite lumière jusqu'à un système de démodulation connecté à des moyens de calcul de puissance ;
- l'élément optique est un cristal électro-optique choisi entre le niobate de lithium, le titanate de lithium, l'arséniure de gallium et le tellure de zinc, ou magnéto-optique ;
- les fibres optiques sont torsadées ;
- une gaine de protection enveloppe la liaison souple et le capteur ;
- la gaine de protection est constituée d'au moins un matériau isolant ;
- la liaison souple comporte également un montage à câble de résistance souple relié à un pont diviseur de tension et intégrant un capteur magnétique de courant à faible isolement monté sur un tore magnétique (transformateur d'intensité) pour la mesure d'intensité.

Ce type d'installation permet tout d'abord un encombrement réduit et une aisance d'installation et d'utilisation. Le capteur électrique de tension et/ou de courant ne nécessite pas d'isolement et, par conséquent, est d'encombrement et de poids réduit. La liaison souple en tant que telle fournit également à l'utilisateur une isolation qui assure ainsi sa sécurité à l'encontre des hautes tensions environnantes et transmet l'information de courant et, éventuellement, de tension.

En outre, la liaison peut être disposée avantageusement de manière amovible sur l'un des supports des moyens d'alimentation.

De manière avantageuse, cette liaison souple est composée d'au moins une fibre optique. Lorsqu'elle est composée de deux fibres optiques, chaque fibre est reliée aux extrémités du capteur de tension et/ou de courant.

Les fibres optiques, du fait des matériaux qui les constituent, offrent de nombreux avantages :
- elles conduisent un flux lumineux, support d'informations, tout en garantissant un fort isolement électrique,
- elles sont souples et ont la caractéristique d'être insensibles à différentes perturbations telles que les champs électromagnétiques extérieurs, assurant ainsi la fiabilité des mesures captées.

Par ailleurs, leur facilité d'installation limite de manière conséquente le temps d'immobilisation des locomotives de matériel roulant.

Avantageusement, le capteur de tension et/ou de courant est un élément optique parcouru par un flux lumineux de lumière cohérente. Ce flux lumineux est émis préférentiellement par une diode laser, acheminé par une première fibre optique vers l'élément optique puis jusqu'à un système de démodulation par une seconde fibre optique.

Lorsque l'élément optique est connecté à un champ électrique créé par une tension, la polarisation de la lumière émise par la diode laser est modulée dans l'élément optique par effet Kerr. De manière équivalente, lorsque l'élément optique est disposé à proximité d'un champ magnétique créé par un courant, la polarisation du flux lumineux est modulée par effet Pockels.

La variation de la polarisation du flux lumineux est alors transformée en une tension et/ou un courant via un système de démodulation, qui sont ensuite traités par des moyens de calculs de puissance.

De manière avantageuse, la liaison souple est protégée par une gaine de protection constituée d'un matériau isolant. Outre l'isolation électrique fournie par cette gaine, elle a également pour but de protéger la liaison contre les pollutions externes et les chocs mécaniques.

Selon un mode de réalisation particulièrement avantageux, l'installation de mesure pour le comptage d'énergie d'alimentation d'un matériel roulant est une liaison souple, de type fibre optique, enroulée autour d'un support des moyens d'alimentation du matériel roulant.

Avantageusement, les capteurs de tension et de courant peuvent être montés ensemble, la liaison souple étant double et formée d'une fibre optique associée à un capteur électrique pour une mesure de courant ou de tension, et d'un câble de résistance souple associé à un capteur magnétique pour une mesure de tension.

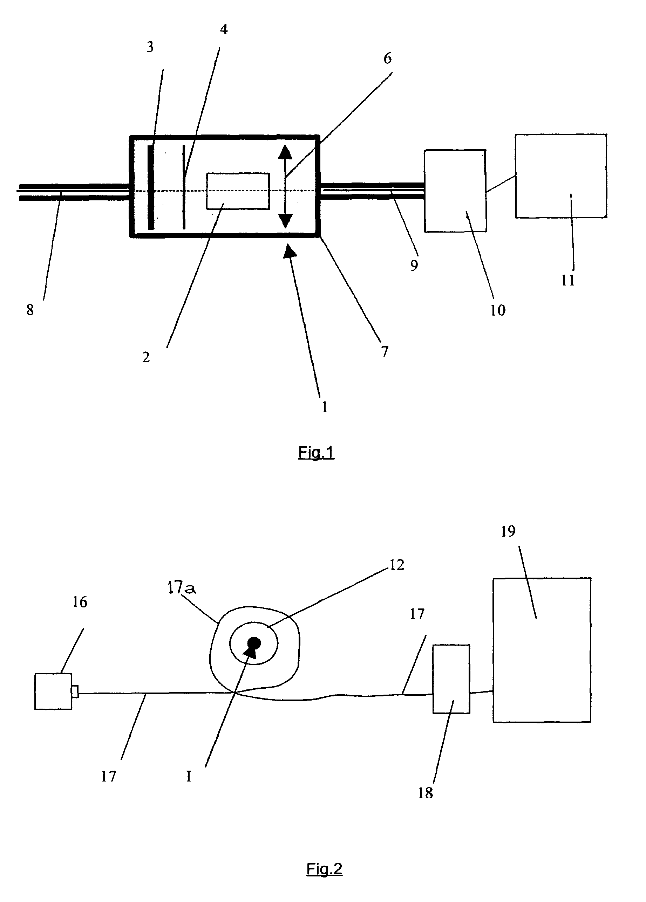

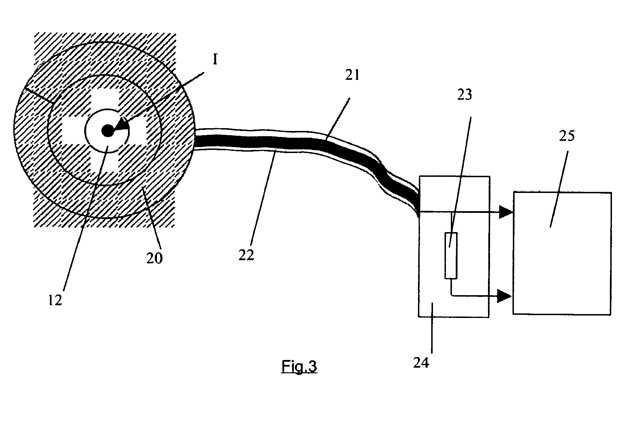

D'autres caractéristiques et avantages de l'invention ressortiront à la lecture qui suit d'exemples de réalisation détaillés, en référence aux figures qui représentent respectivement :
- en figure 1, un exemple de capteur de mesure de tension en complément de l'installation,
- en figure 2, un exemple de capteur de mesure de courant dans une installation disposée sur un moyen d'alimentation selon l'invention et,
- en figure 3, un exemple de mesure à câble de résistance souple monté en complément.

Sur la figure 1 est représenté un moyen de mesure de tension à prévoir en complément de l'installation. Ce moyen de mesure est un capteur de mesure optique 1 intégré dans une liaison souple constituée de deux fibres optiques torsadées 8 et 9. Le capteur de mesure 1 comporte en outre un cristal électro-optique 2 constitué de niobate de lithium. L'élément optique 2 est traversé par un flux lumineux cohérent amené via une première fibre optique 8. Soumis à un champ électrique, le cristal 2 modifie la polarisation de la lumière cohérente qui le traverse par le biais de l'effet Kerr. Cet effet dépend de manière quadratique du champ électrique à mesurer et est par conséquent adapté aux mesures de champs importants.

L'élément optique 2 est précédé d'un film polariseur 3 et d'une lame quart d'onde 4. La conjugaison de ces deux composants optiques permet de polariser la lumière cohérente entrant dans la sonde de manière circulaire.

Par l'intermédiaire du champ électrique à mesurer, la polarisation de la lumière en sortie de l'élément optique 2 est finalement polarisée elliptiquement. Ce changement de direction de polarisation va induire des variations d'intensité lumineuse qui vont être détectées et analysées par un système de démodulation 10 et des moyens de calculs de puissance 11. En effet, à la sortie du capteur 1, la lumière, dont la polarisation a été modifiée, est focalisée par la lentille convergente 6 dans une seconde fibre optique 9 reliée au système de démodulation 10, lui-même connecté à des moyens de calculs de puissance 11.

Le capteur 1 et la liaison souple 8 et 9 sont protégés dans une gaine de protection mécanique et électrique 7, en caoutchouc, qui a pour effet secondaire de renforcer le champ électrique à l'intérieur de l'élément 2 et par conséquent, d'améliorer la sensibilité de la mesure optique.

Dans l'exemple de réalisation, l'élément optique 2 est constitué d'un cristal de niobate de lithium (LiNb03). Alternativement, il est possible d'utiliser du titanate de lithium (LiTa02), de l'arséniure de gallium (AsGa) ou du tellure de zinc (ZnTe). De manière avantageuse, il est également possible d'utiliser un cristal magnéto-optique.

Sur la figure 2 est représentée une vue de l'installation d'un moyen de mesure de courant selon l'invention, enroulée autour d'un moyen d'alimentation d'un matériel roulant.

La lumière cohérente est émise par une diode laser 16 et est introduite dans une fibre optique 17 à 633nm. Dans cet exemple de réalisation, la mesure de courant est effectuée uniquement via la fibre optique 17. En effet, un enroulement 17a de la fibre 17 autour du conducteur 12 en sortie de pantographe délivre le courant I et permet de réaliser des mesures de courant en fonction du nombre de tours effectués autour du conducteur 12. L'enroulement 17a de la fibre optique 17 autour du conducteur 12 délivrera une valeur de courant démodulée à partir des variations d'intensité lumineuse induites par l'enroulement 17a. Les variations d'intensité lumineuse en sortie de la fibre optique 17 étant proportionnelles aux nombres de tours réalisés autour du conducteur 12, il suffit d'ajuster les paramètres d'un système de démodulation 18 disposé en sortie de la fibre optique 17.

En sortie de la fibre optique 17, les variations d'intensité lumineuse sont donc recueillies par le système de démodulation 18, qui les transforment en valeurs d'intensité, valeurs qui sont ensuite traitées par des moyens de calculs de puissance 19.

Une installation de mesure d'énergie selon l'invention est conforme aux exigences de la norme ferroviaire EN 50463. Par exemple, pour une locomotive alimentée par une caténaire de 25000 V, le captage de l'énergie par la locomotive se fait au moyen d'un pantographe fixé sur sa toiture :
- pour la mesure de tension, réalisée selon la figure 1, le capteur de mesure optique 1 est placé à l'intérieur d'un des plots isolants qui supportent le pantographe sur la toiture de la locomotive; le pôle supérieur du plot étant au potentiel de la caténaire et le pôle inférieur au potentiel du rail par liaison au châssis de la locomotive, cette disposition fournit une valeur de la tension caténaire. Les autres éléments électroniques et optiques sont installés dans une des armoires électriques du véhicule qui forme un endroit protégé et facilement accessible pour la maintenance ;
- la mesure du courant est réalisée selon la figure 2 en enroulant la fibre optique 17 au plus près du point de captage, soit à la sortie du pantographe. Les autres éléments électroniques et optiques sont installés avec ceux de la mesure de la tension dans une armoire électrique du véhicule ;
- un compteur d'énergie électrique, connecté aux sorties des systèmes de mesure de courant et de tension, calcule et mémorise l'énergie active et réactive qui est consommée ou produite par la locomotive. Un récepteur de type GPS raccordé au compteur permet à ce dernier de localiser et de dater les mesures d'énergie et l'ajout d'un modem GPRS ou équivalent permet le télé-relevé des mesures.

En référence à la figure 3, il est représenté une vue d'une installation complémentaire à câble, disposée autour d'un moyen d'alimentation 12 d'un matériel roulant, comportant un capteur magnétique 20 relié à une première extrémité de la liaison.

Selon un mode de réalisation particulier, ce capteur 20 est un transformateur d'intensité à faible niveau d'isolement chargé sur une résistance. La bobine est positionnée autour du conducteur 12 en sortie de pantographe, dont on souhaite connaître la valeur du courant I qu'elle transporte. La tension induite dans la résistance de charge du transformateur d'intensité est proportionnelle au courant I du conducteur 12.

Le capteur 20 est relié alors à un circuit d'intégration électrique 24 à forte impédance d'entrée de type pont diviseur de tension par l'intermédiaire du câble à résistance souple, afin de fournir un signal de sortie qui est proportionnel au courant I.

Dans cet exemple, la liaison souple est composée d'un câble constitué d'un conducteur haute tension 21, fil hautement résistif ou fil de carbone, entouré par une gaine à base de matériau siliconé 22, silicone ou carbone siliconé. Le câble est relié au pont diviseur comportant la résistance étalon 23.

Pour la mesure des paramètres de tension fournis à travers le conducteur 12, il est possible de n'utiliser qu'un seul câble. Il crée une résistance souple de plusieurs mètres possédant une valeur de 100MΩ/m. La première extrémité du câble est reliée au potentiel à mesurer et la seconde à la résistance étalon 23, dans laquelle une image de la tension mesurée est déterminée par le pont diviseur de tension.

Les différentes mesures sont lues en sortie du pont diviseur de tension par des moyens de calculs de puissance 25.

Toutefois, la stabilité de la mesure de cette installation, dans le temps et dans le cas de variations de température, est faible.

Par conséquent, il est avantageux de prévoir un câble double pour effectuer une double mesure par compensation entre les énergies à mesurer et les énergies dans la résistance étalon.

De même, afin de renforcer l'isolation de l'installation, il est avantageux d'utiliser un câble de résistance souple équipé d'une double isolation électrique à base de matériaux siliconés ou encore à base de polyester ou de kapton, ce dernier polymère étant déjà utilisé dans la construction des moteurs de traction de trains.

L'invention n'est pas limitée aux exemples de réalisations décrits et représentés précédemment. Compte tenu, du faible encombrement et de la souplesse d'utilisation de l'installation, une autre variante d'utilisation de l'installation selon l'invention peut être un instrument de mesure d'énergies portable ou encore une pince voltampère métrique.

## Revendications

1. Installation de mesure pour le comptage d'énergie d'alimentation d'un matériel roulant comportant des moyens d'alimentation de puissance fournis en liaison avec le matériel roulant, **caractérisée en ce qu'**elle comporte une liaison souple composée d'au moins une fibre optique (8, 9, 17) associée à un capteur de courant (17a), la fibre (17) étant apte à transmettre une information de courant par modulation d'un flux lumineux introduit dans la fibre (17) à travers le capteur de courant formé par un enroulement (17a) de la fibre optique (17) autour d'un support (12) des moyens d'alimentation de puissance, l'information étant transmise à des moyens de démodulation (18) connectés à des moyens de compteur d'énergie (19).

2. Installation de mesure selon la revendication 1, dans laquelle la liaison souple a également une fonction d'isolation électrique.

3. Installation de mesure selon la revendication 1 ou 2, dans laquelle des moyens d'émission (16) sont aptes à introduire une lumière cohérente dans la fibre optique (17), et l'enroulement (17a) de la fibre (17) autour d'un conducteur (12) d'alimentation de courant (I) en sortie de pantographe, est alors apte à moduler la lumière en fonction du nombre de tours effectués autour du conducteur (12).

4. Installation de mesure selon la revendication précédente, dans laquelle la mesure est effectuée à partir des variations d'intensité lumineuse induites par l'enroulement (17a) en sortie de la fibre optique (17) proportionnellement au nombre de tours réalisé autour du conducteur (12), les variations lumineuses étant recueillies et transformées en valeurs d'intensité par un système de démodulation (18), disposé en sortie de la fibre optique (17) et connecté à des moyens de calcul de puissance (19) de traitement des valeurs d'intensité.

5. Installation de mesure selon l'une quelconque des revendications précédentes, dans laquelle un capteur de tension complémentaire (1) par modulation d'une lumière cohérente à l'aide d'un élément optique (2) de modulation est prévu, la modulation étant induite par un champ électrique créé par la tension fournie par les moyens d'alimentation, la lumière cohérente étant acheminée en entrée de l'élément optique par une première fibre optique (8) et l'élément optique (2) étant relié en sortie à une seconde fibre optique (9) guidant la lumière modulée jusqu'à un système de démodulation (10) connecté à des moyens de compteur d'énergie (11).

6. Installation de mesure selon la revendication précédente, dans laquelle le capteur de tension (1) est un cristal électro-optique (2).

7. Installation de mesure selon la revendication précédente, **caractérisée en ce que** le cristal électro-optique (2) est constitué d'un matériau choisi entre le niobate de lithium, le titanate de lithium, l'arséniure de gallium et le tellure de zinc.

8. Installation de mesure selon la revendication 7, dans laquelle le capteur de tension (1) est un cristal magnéto-optique.

9. Installation de mesure selon l'une quelconque des revendications précédentes, dans laquelle les fibres optiques (8, 9, 17) sont torsadées.

10. Installation de mesure selon l'une quelconque des revendications précédentes, dans laquelle une gaine de protection (7) enveloppe la liaison souple (8, 9, 17) et le capteur (1).

11. Installation de mesure selon la revendication précédente, dans laquelle la gaine de protection (7) est constituée d'au moins un matériau isolant.

12. Installation de mesure selon la revendication 1 ou 2, dans laquelle la liaison souple comporte également un montage à câble de résistance souple (21), relié à un pont diviseur de tension (24) relié à un compteur d'énergie (25) et intégrant un capteur de courant à faible isolement (20).

13. Installation de mesure selon l'une quelconque des revendications précédentes, dans laquelle le compteur d'énergie électrique (11, 19), connecté aux sorties des systèmes de mesure de courant et de tension (10, 18), calcule et mémorise l'énergie active et réactive qui est consommée ou produite par le matériel roulant, par exemple une locomotive, et dans laquelle un récepteur de type GPS est raccordé au compteur (11, 19) aux fins de localisation et de datation des mesures d'énergie, en association avec un modem GPRS ou équivalent permettant le télé-relevé de ces mesures.
